# EUROPEAN PATENT APPLICATION

(11) **EP 4 600 998 A1**
(43) Date of publication of application: **13.08.2025**
(21) Application number: 23874941.0
(22) Date of filing: 05.10.2023
(51) Int. Cl.: H01L 23/02, H01L 23/12, H05K 1/02

(54) **WIRING BOARD, ELECTRONIC COMPONENT MOUNTING PACKAGE USING WIRING BOARD, AND ELECTRONIC MODULE**

(30) Priority: 07.10.2022 JP 2022162527
(71) Applicant: Kyocera Corporation, Kyoto-shi, Kyoto 612-8501 (JP)
(72) Inventor: KAWAZU, Yoshiki, Kyoto-shi, Kyoto 612-8501 (JP)
(74) Representative: Viering, Jentschura & Partner mbB Patent- und Rechtsanwälte
(86) International application number: PCT/JP2023/036390
(87) International publication number: WO 2024/075816

(57) **Abstract**

A wiring board includes a basal portion, a dielectric substrate, and a first signal conductor. The basal portion includes a first upper surface, a first lower surface, a first side surface, and a first opening opened in the first upper surface. The dielectric substrate includes a second upper surface, a second lower surface, and a second side surface. The dielectric substrate is positioned on the first upper surface. The second side surface is positioned along the first side surface. The first signal conductor is positioned on the second upper surface. The first signal conductor includes a first line portion extending in a first direction to be away from the second side surface, and a first joint positioned between the first line portion and the second side surface. The first joint is larger in maximum size than the first line portion in a second direction along the first side surface. **In** a planar view, the first opening is positioned to be overlapped with at least part of the first joint.

## Description

### TECHNICAL FIELD

The present disclosure relates to a wiring board, an electronic component mounting package including the wiring board, and an electronic module.

### BACKGROUND OF INVENTION

Electronic modules included in wireless communication devices and optical communication devices have recently been required to deal with higher frequency signals for transmission of information having larger volume at higher speed. Wiring boards configured to transmit signals have thus been required to transmit radio-frequency signals with smaller losses.

A known structure for transmission of such signals includes a base made of a metal member and a terminal portion bonded to the base. The terminal portion includes a ceramic member and a conductive portion provided on the ceramic member (see Patent Literature 1). In the structure according to Patent Literature 1, a lead can be bonded to the conductive portion.

### CITATION LIST

### PATENT LITERATURE

Patent Literature 1: Japanese Unexamined Patent Application Publication No. 2018-37564

### SUMMARY

According to an embodiment of the present disclosure, (1) a wiring board includes a basal portion made of a metallic material, a dielectric substrate, and a first signal conductor. The basal portion includes a first upper surface, a first lower surface, a first side surface, and a first opening opened in the first upper surface. The first lower surface is positioned opposite to the first upper surface. The first side surface is connected to the first upper surface and the first lower surface. The dielectric substrate includes a second upper surface, a second lower surface, and a second side surface. The dielectric substrate is positioned on the first upper surface. The second lower surface is positioned opposite to the second upper surface. The second side surface is connected to the second upper surface and the second lower surface. The second side surface is positioned along the first side surface. The first signal conductor is positioned on the second upper surface. The first signal conductor includes a first line portion extending in a first direction to be away from the second side surface, and a first joint positioned between the first line portion and the second side surface. The first joint is larger in maximum size than the first line portion in a second direction along the first side surface. In a planar view, the first opening is positioned to be overlapped with at least part of the first joint.

(2) The wiring board according to (1) described above further includes a lower-surface ground conductor positioned on the second lower surface. The lower-surface ground conductor includes a first opening region. In a planar view, the first opening region is positioned in the first opening to be overlapped with the first joint.

(3) In the wiring board according to (1) or (2) described above, the first opening is positioned to cross the first side surface.

(4) In the wiring board according to (1) to (3) described above, the first opening is equal in maximum size to or more than the first joint in the second direction along the first side surface.

(5) In the wiring board according to (1) to (4) described above, the dielectric substrate further includes a first recess. In this case, the first recess is positioned to cross the second upper surface and the second side surface. The first recess is positioned to be overlapped with the first opening in a planar view. The first recess may include a first inner wall surface. The first inner wall surface is provided continuously to the second upper surface and the second side surface. The first signal conductor is positioned to extend so as to reach the first inner wall surface. In this case, the first recess is smaller in maximum size in the second direction along the second side surface than the first joint in a planar view.

(6) In the wiring board according to (5) described above, the first opening is larger in maximum size in the first direction than the first recess in a planar view.

(7) In (1) to (6) described above, the wiring board further includes an upper-surface ground conductor and an internal-layer ground conductor. The upper-surface ground conductor is positioned on the second upper surface to be spaced apart from the first signal conductor. The internal-layer ground conductor is positioned in the dielectric substrate. The first joint includes a first end portion positioned adjacent to the second side surface. The upper-surface ground conductor includes a second end portion positioned adjacent to the second side surface. The internal-layer ground conductor includes a third end portion positioned adjacent to the second side surface. In a side view, a minimum distance in the second direction between the first end portion and the second end portion is larger than a minimum distance in the second direction between the first end portion and the third end portion.

(8) In the wiring board according to (1) to (7) described above, the first joint includes a protrusion. The protrusion is provided on the second upper surface along the second side surface and projects in the second direction.

(9) In (1) to (8) described above, the wiring board further includes a first connector electrically connected to the first joint. The first connector includes a first tip portion overlapped with the first joint in a planar view. The first tip portion is positioned in the first opening in a planar view.

(10) In the wiring board according to (9) described above, the first connector is smaller in maximum size in the second direction than the first opening.

(11) In the wiring board according to (9) or (10) described above, a maximum distance in the first direction from the first side surface to an inner edge of the first opening is longer than a maximum size in the first direction from the first side surface to the first tip portion.

(12) In (5) or (6) described above, the wiring board further includes a first connector electrically connected to the first joint. In a planar view, at least part of the first connector is positioned to be overlapped with the first recess.

(13) In the wiring board according to (1) to (12) described above, the dielectric substrate further includes a second recess opened in the second lower surface. In a planar view, the second recess is positioned to be overlapped with at least part of the first signal conductor.

(14) In the wiring board according to (13) described above, the second recess is positioned to be overlapped with at least part of the first opening in a planar view. In a planar view, the second recess is equal in maximum size in the first direction to or less than the first opening.

(15) In the wiring board according to (5) to (12) described above, the dielectric substrate further includes a second recess opened in the second lower surface. In a planar view, the second recess is positioned to be overlapped with at least part of the first signal conductor. In a planar view, the second recess is larger in maximum size in the first direction than the first recess.

(16) According to an embodiment of the present disclosure, an electronic component mounting package includes a frame, and the wiring board according to (1) to (15) described above fixed to the frame. The frame is bonded onto at least one of the basal portion and the dielectric substrate.

(17) According to an embodiment of the present disclosure, an electronic module includes the electronic component mounting package according to (16) described above, an electronic component, and a lid. The electronic component is positioned on the basal portion or the dielectric substrate, and is electrically connected to the wiring board. The lid is positioned on the frame to cover an interior of the electronic component mounting package.

### BRIEF DESCRIPTION OF THE DRAWINGS

FIG. 1 is a perspective view of a wiring board and an electronic component mounting package according to a first embodiment of the present disclosure.
FIG. 2 is an enlarged view of a principal part A indicated in FIG. 1.
FIG. 3 is a perspective view from a negative side of a z axis, of the principal part A indicated in FIG. 1 excluding a basal portion.
FIG. 4 is an enlarged plan view of the principal part A indicated in FIG. 1.
FIG. 5 is a view obtained by excluding connectors from FIG. 2.
FIG. 6 is a view obtained by excluding connectors from FIG. 4.
FIG. 7 is a side view in an x axis direction, of the wiring board illustrated in FIG. 5.
FIG. 8 is an enlarged perspective view of the basal portion according to the first embodiment of the present disclosure.
FIG. 9 is a plan view of the basal portion illustrated in FIG. 8.
FIG. 10 is a perspective view of a basal portion according to variation 1.
FIG. 11 is a perspective view of a basal portion according to variation 2.
FIG. 12 is a perspective view of a dielectric substrate according to variation 1.
FIG. 13A is a perspective view of FIG. 12 from the negative side of the z axis, illustrating the dielectric substrate according to variation 1.
FIG. 13B is a plan view of FIG. 13A from the negative side of the z axis, illustrating the dielectric substrate according to variation 1.
FIG. 14A is a perspective view of a dielectric substrate according to variation 2.
FIG. 14B is a plan view of FIG. 14A from the negative side of the z axis, illustrating the dielectric substrate according to variation 2.
FIG. 15A is a perspective view of a dielectric substrate according to variation 3.
FIG. 15B is a plan view of FIG. 15A from the negative side of the z axis, illustrating the dielectric substrate according to variation 3.
FIG. 16 is an exploded perspective view of a joint between a wiring board and an external substrate excluding connectors.
FIG. 17 is a plan view of a joint between a wiring board and an external substrate, and a first connector according to variation 1.
FIG. 18A is a perspective view of a first connector according to variation 2.
FIG. 18B is a plan view of the first connector according to variation 2.
FIG. 19A is a perspective view of a first connector according to variation 3.
FIG. 19B is a side view of the first connector according to variation 3.
FIG. 20A is a perspective view of a first connector according to variation 4.
FIG. 20B is a side view of the first connector according to variation 4.
FIG. 20C is a plan view of the first connector according to variation 4.
FIG. 21 is a perspective view of a wiring board according to a second embodiment of the present disclosure.
FIG. 22 is a perspective view of the wiring board according to the second embodiment of the present disclosure, the wiring board including a basal portion according to variation 3.
FIG. 23 is a perspective view from the negative side of the z axis, of the wiring board illustrated in FIG. 22.
FIG. 24 is an exploded perspective view of a wiring board, an electronic component mounting package, and an electronic module according to an embodiment of the present disclosure.

### DESCRIPTION OF EMBODIMENTS

### <Configuration of wiring board>

Several exemplary embodiments of the present disclosure will be described hereinafter with reference to the drawings. A wiring board may be disposed to include a top or a bottom in any direction. For convenience, the wiring board is defined to have an orthogonal coordinate system xyz, and a positive side in a z direction is assumed to indicate an upper side. The following description refers to a first direction exemplarily indicating an x direction in the drawings. A second direction exemplarily indicates a y direction in the drawings. In the present disclosure, a planar view conceptually includes a plan perspective view. In the present disclosure, a side view conceptually includes a side perspective view.

Description of a basal portion 1 and a dielectric substrate 2 according to each variation will refer only to configurations different from the embodiments. The remaining configurations will be denoted by reference signs identically or similarly to the embodiments and will not be described repeatedly.

### (First Embodiment)

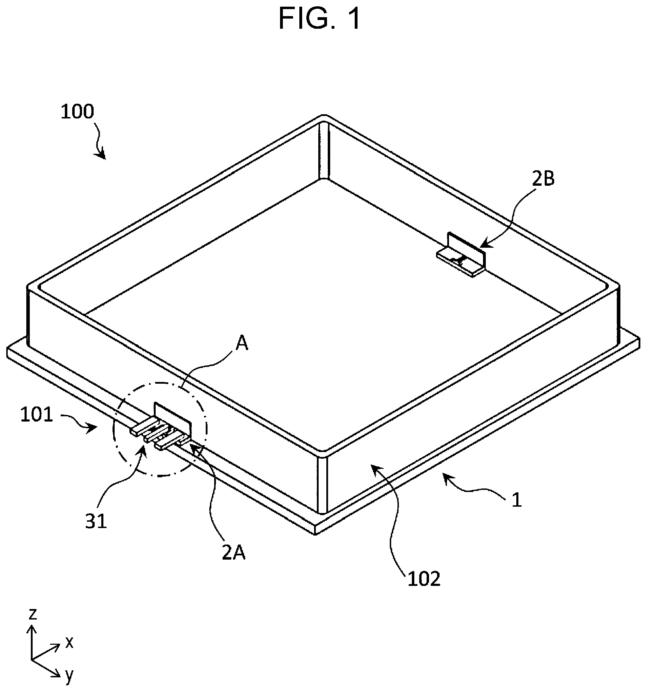

Description is made to a wiring board 101 according to the first embodiment of the present disclosure with reference to FIGs. 1 to 9.

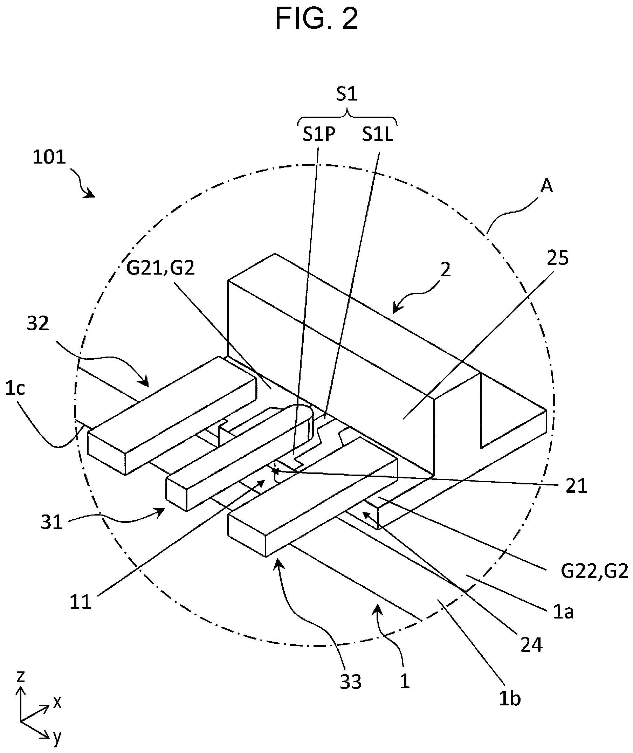

As illustrated in FIGs. 2 to 6, the wiring board 101 includes a basal portion 1 made of a metallic material, a dielectric substrate 2, and a first signal conductor S1.

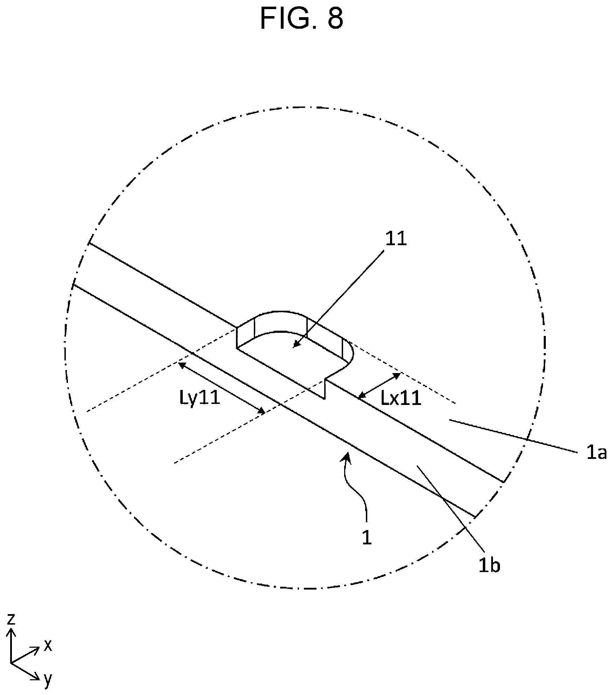

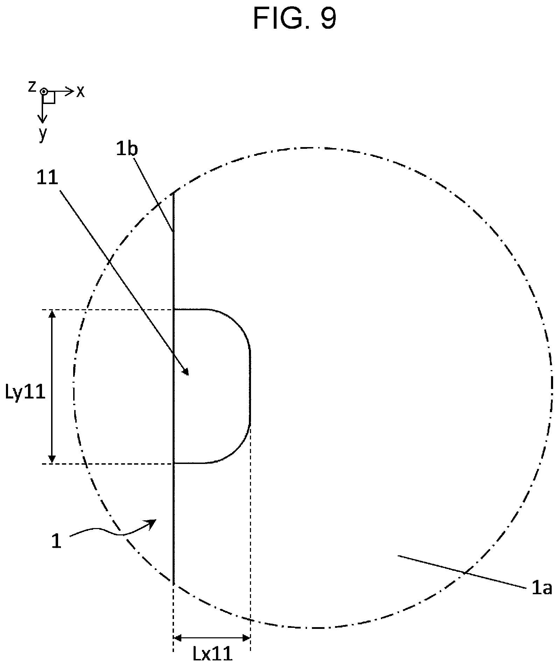

As illustrated in FIGs. 8 and 9, the basal portion 1 includes a first upper surface 1a, a first lower surface 1c, a first side surface 1b, and a first opening 11 opened in the first upper surface 1a. The first lower surface 1c is positioned opposite to the first upper surface 1a. The first side surface 1b is connected to the first upper surface 1a and the first lower surface 1c. The first upper surface 1a may include a region equipped with an electronic component 103 to be described later. The basal portion 1 exemplarily has a quadrilateral shape in a planar view having 10 mm × 10 mm to 50 mm × 50 mm in size and 0.5 mm to 20 mm in thickness. Examples of the metallic material for the basal portion 1 include metallic materials such as copper, iron, tungsten, molybdenum, nickel, and cobalt, and an alloy containing any of these metallic materials. In this case, the basal portion 1 may be constituted by a single metal plate or a stacked body including a plurality of stacked metal plates. When the basal portion 1 is made of any one of the above metallic materials, the basal portion 1 may be provided on its surface with a plated layer of nickel, gold, or the like in accordance with an electroplating method or an electroless plating method for suppression of oxidation corrosion. The state where the basal portion 1 is made of a metallic material herein may mean a state where the basal portion 1 is substantially made of the metallic material, and may exemplarily include a state where the basal portion 1 contains a nonmetallic material unavoidable for production.

As illustrated in FIGs. 2 to 6, the dielectric substrate 2 is positioned on the first upper surface 1a. The dielectric substrate 2 includes a second upper surface 2a, a second lower surface 2c, and a second side surface 2b. The second lower surface 2c is positioned opposite to the second upper surface 2a. The second side surface 2b is connected to the second upper surface 2a and the second lower surface 2c. The second side surface 2b is positioned along the first side surface 1b. Examples of a material for the dielectric substrate 2 can include dielectric materials including a ceramic material such as an aluminum oxide sintered body, a mullite sintered body, a silicon carbide sintered body, an aluminum nitride sintered body, or a silicon nitride sintered body, a glass ceramic material, and a glass epoxy material. As to be described later in a second embodiment, the dielectric substrate 2 may be a printed circuit board (PCB).

The dielectric substrate 2 can be bonded to the basal portion 1 via an adhesive such as solder, brazing filler metal, glass, or a resin adhesive. The brazing filler metal is made of a material, examples of which include silver, copper, gold, aluminum, and magnesium, and the material may contain an additive such as nickel, cadmium, or phosphorus.

In an embodiment, the dielectric substrate 2 is positioned on part of the first upper surface 1a of the basal portion 1. Alternatively, the dielectric substrate 2 may be positioned to entirely cover the first upper surface 1a. In this case, the second upper surface 2a of the dielectric substrate 2 may include a region equipped with the electronic component 103 to be described later.

The dielectric substrate 2 may be constituted by a single layer or a plurality of stacked dielectric layers. The dielectric substrate 2 exemplarily has a rectangular shape in a planar view having 4 mm × 4 mm to 50 mm × 50 mm in size and 0.5 mm to 10 mm in thickness.

The dielectric substrate 2 may further include a dielectric layer positioned on the second upper surface 2a. In this case, the dielectric layer positioned on the second upper surface 2a may cover part of the second upper surface 2a or may entirely cover the second upper surface 2a. In an embodiment, the dielectric substrate 2 exemplarily includes a wall portion 25. The wall portion 25 is positioned to be overlapped with part of the first signal conductor S1 in a planar view. The wall portion 25 includes an upper surface and a side surface each of which may be provided with a conductor for grounding.

The dielectric substrate 2 can be manufactured in the following exemplary manner. A plurality of green sheets is processed with use of a die or the like to prepare a plurality of green sheets formed into an outer shape of the dielectric substrate 2. Subsequently, the plurality of green sheets is stacked to match outer edge portions so as to form a green sheet stacked body. The green sheet stacked body is burned to sinter the plurality of green sheets so as to obtain the dielectric substrate 2.

As illustrated in FIGs. 2 to 6, the first signal conductor S1 is positioned on the second upper surface 2a. The first signal conductor S1 includes a first line portion S1L extending in the first direction (x direction) to be away from the second side surface 2b, and a first joint S1P positioned between the first line portion S1L and the second side surface 2b. The first signal conductor S1 is made of a material, examples of which include metallic materials such as gold, silver, copper, nickel, tungsten, molybdenum, and manganese. The first signal conductor S1 may be formed by sintering a metal paste on the second upper surface 2a, or may be formed in accordance with a thin film forming technique such as an evaporation method or a sputtering method. The first signal conductor S1 exemplarily has 0.05 mm to 2 mm in width and 1.5 mm to 25 mm in length. The first signal conductor S1 exemplarily has 0.01 mm to 0.1 mm in thickness. The width, length, and thickness of the first signal conductor S1 herein can be a size in the x direction, a size in the y direction, and a size in the z direction of the first signal conductor S1, respectively. The first signal conductor S1 may be inconstant in width, length, or thickness, and may be varied halfway.

The first signal conductor S1 includes a surface that may be plated with a metal such as nickel or gold. Part of the first signal conductor S1 may be provided thereon with an insulating film made of a ceramic (e.g., alumina coating), a resin, or the like. The insulating film can be formed on the first signal conductor S1 by screen printing. The insulating film may alternatively be positioned only on part of the first signal conductor S1. Such a configuration is less likely to cause a short circuit between the first signal conductor S1 and other wiring.

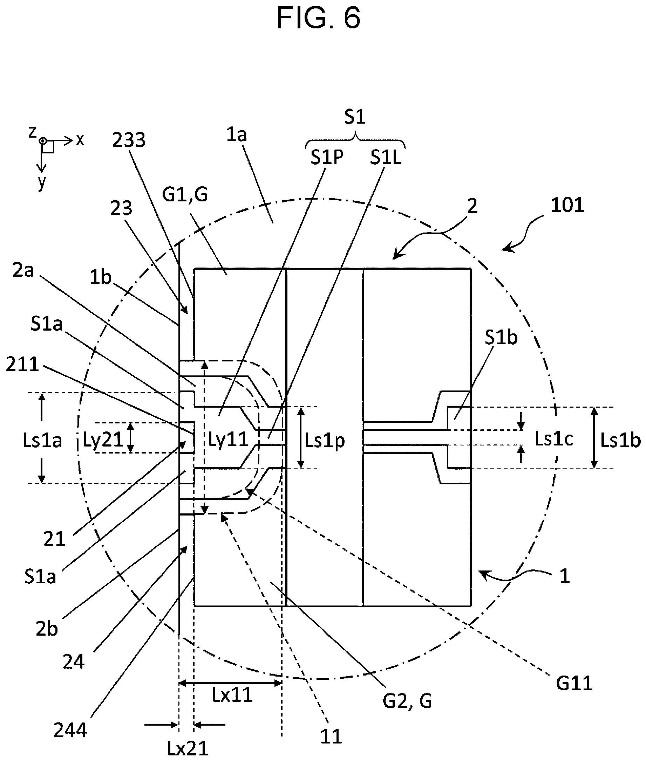

As illustrated in FIG. 6, in an embodiment, the first signal conductor S1 is positioned in contact with the second side surface 2b in a planar view. In other words, the first signal conductor S1 is positioned to reach the second side surface 2b. The first signal conductor S1 is not necessarily in contact with the second side surface 2b, and may alternatively be positioned apart from the second side surface 2b in a planar view.

As illustrated in FIG. 6, the first joint S1P has a maximum size Ls1a in the y direction larger than a maximum size Ls1c in the y direction of the first line portion S1L. Such a configuration achieves stable connection of a first connector 31 to be described later.

As illustrated in FIG. 6, the first joint S1P includes a protrusion S1a to be described later in an embodiment. The maximum size Ls1a in the y direction of the first joint S1P may thus correspond to a size of the first joint including the protrusion S1a in an embodiment. The first joint S1P excluding the protrusion S1a has a size Ls1p in the y direction larger than the maximum size Ls1c in the y direction of the first line portion S1L in an embodiment.

As illustrated in FIG. 6, the first signal conductor S1 includes a second joint S1b opposite (on the positive side of an x axis) to the first joint S1P in an embodiment. The second joint S1b has a maximum size Ls1b in the y direction larger than the maximum size Ls1c in the y direction of the first line portion S1L. A conductive connector such as a lead terminal or a wire may be bonded to the second joint S1b identically or similarly to the first joint S1P.

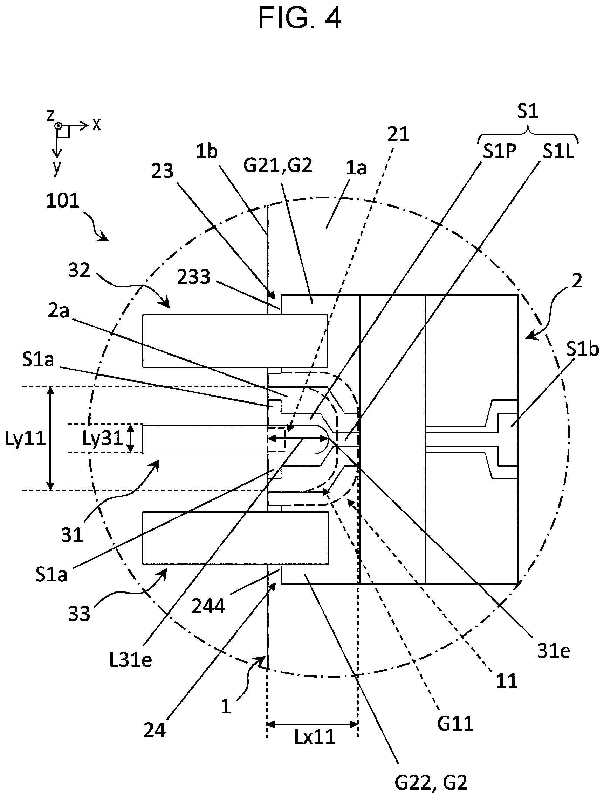

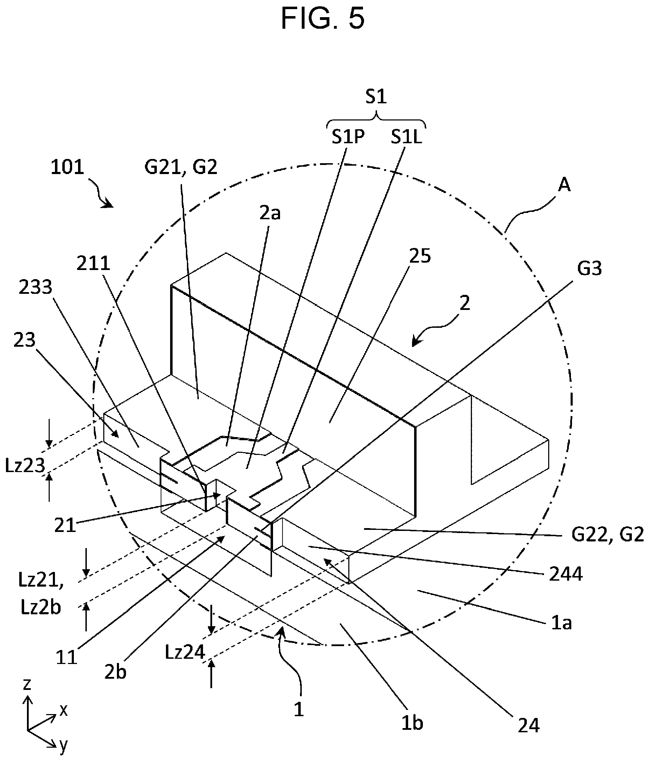

As illustrated in FIGs. 4 and 5, the wiring board 101 may include an upper-surface ground conductor G2 positioned on the second upper surface 2a. In an embodiment, the upper-surface ground conductor G2 includes a first upper-surface ground conductor G21 and a second upper-surface ground conductor G22. In this case, the first signal conductor S1 is positioned between the first upper-surface ground conductor G21 and the second upper-surface ground conductor G22. Such a configuration strengthens ground potential and electrolytic coupling, and is thus less likely to cause crosstalk and resonance generated by an electric field distribution expanding beyond a desired range upon transmission of a radio-frequency signal.

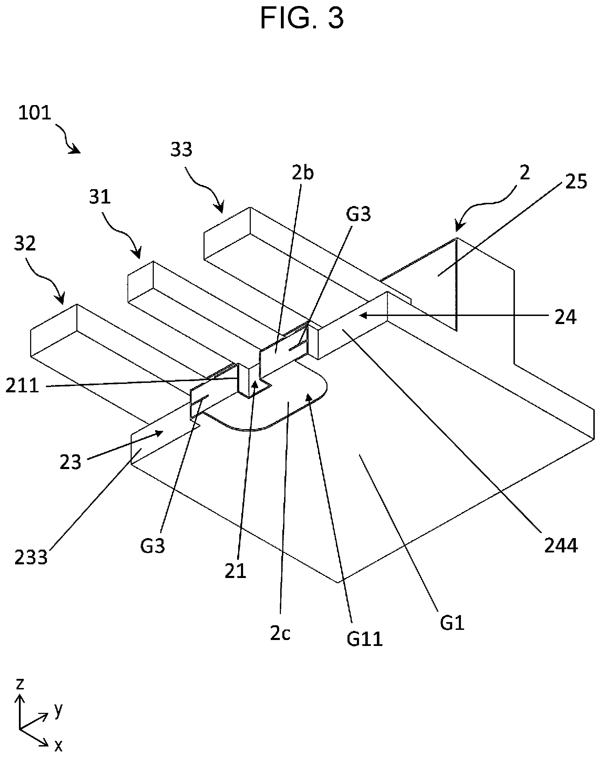

As illustrated in FIGs. 3 and 4, the second lower surface 2c may be provided with a lower-surface ground conductor G1. The lower-surface ground conductor G1 includes a first opening region G11. More specifically, the second lower surface 2c is exposed at a position overlapped with the first opening region G11 in a planar view from the negative side of a z axis. In a planar view, the first opening region G11 is positioned in the first opening 11 and is overlapped with the first joint S1P. Such a configuration can secure a distance from meal portions (the basal portion 1 and the lower-surface ground conductor G1) proximate to the first joint S1P in the z direction. This is less likely to decrease an impedance value around a joint of the first connector 31 when the first signal conductor S1 includes the first joint S1P for stable connection of the first connector 31 to be described later. Furthermore, the first opening region G11 is positioned in the first opening 11 in a planar view to further decrease an effective relative dielectric constant around the first connector 31. This is further less likely to decrease the impedance value around the joint of the first connector 31.

As illustrated in FIG. 3, the first opening region G11 is positioned to cross the second side surface 2b in an embodiment. However, the first opening region G11 is not necessarily positioned to cross the second side surface 2b. That is, the first opening region G11 may be positioned to be spaced apart from the second side surface 2b in a planar view.

The lower-surface ground conductor G1 may be electrically connected to the first upper-surface ground conductor G21, the second upper-surface ground conductor G22, and an internal-layer ground conductor G3 to be described later by a via provided in the dielectric substrate 2 and a conductor provided on any of side surfaces including the second side surface 2b of the dielectric substrate 2. The lower-surface ground conductor G1 may further be electrically connected to the basal portion 1.

As illustrated in FIGs. 4 and 6, the first opening 11 is positioned to be overlapped with at least part of the first signal conductor S1 in a planar view. Such a configuration can reduce the volume of the basal portion 1 positioned to be overlapped with the first signal conductor S1 in a planar view. The first opening 11 is filled with air or a dielectric material such as a resin material or a glass material so as to be lower in dielectric constant than the basal portion 1. This is less likely to decrease the impedance value when the first signal conductor S1 includes the first joint S1P for stable connection of the first connector 31 to be described later.

In an embodiment, the first opening 11 is shaped to be cut off from the first upper surface 1a to the first side surface 1b. The first opening 11 may alternatively be shaped to be cut off across the first upper surface 1a, the first side surface 1b, and the first lower surface 1c as in a basal portion 1 according to variation 1 to be described later. The first opening 11 may still alternatively have a recessed shape having an opening in the first upper surface 1a as in a basal portion 1 according to variation 2 to be described later. In an embodiment, the first opening 11 has a rectangular shape with some rounded corner in a planar view. The first opening 11 may alternatively have a rectangular shape or a circular shape. The basal portion 1 may include a plurality of first openings 11.

The first signal conductor S1 may be positioned at the center in the y direction of the first opening 11 in a planar view. That is, the first opening 11 may be positioned line symmetrically with respect to the first signal conductor S1 in a planar view. Such a configuration can equivalently decrease the basal portion 1 positioned on the right and left sides of the first signal conductor S1 to facilitate adjustment of the impedance value at the first signal conductor S1.

As illustrated in FIGs. 4 and 6, the second side surface 2b may be positioned along the first side surface 1b in a planar view. In this case, the first opening 11 may be positioned to cross the first side surface 1b as illustrated in FIGs. 8 and 9. More specifically, the first opening 11 may be shaped to be cut off from the first upper surface 1a to the first side surface 1b. Such a configuration is further efficiently less likely to decrease the impedance at the first signal conductor S1.

The basal portion 1 and the first opening 11 illustrated in FIGs. 8 and 9 can be manufactured by stacking a metal plate formed to have an outer shape of the basal portion 1 including the first opening 11 and a metal plate shaped to have the outer shape of the basal portion 1. Such a configuration enables a reduction of manufacturing processes for the basal portion 1 constituted by a stacked body in comparison to the basal portion 1 according to variation 1 to be described later.

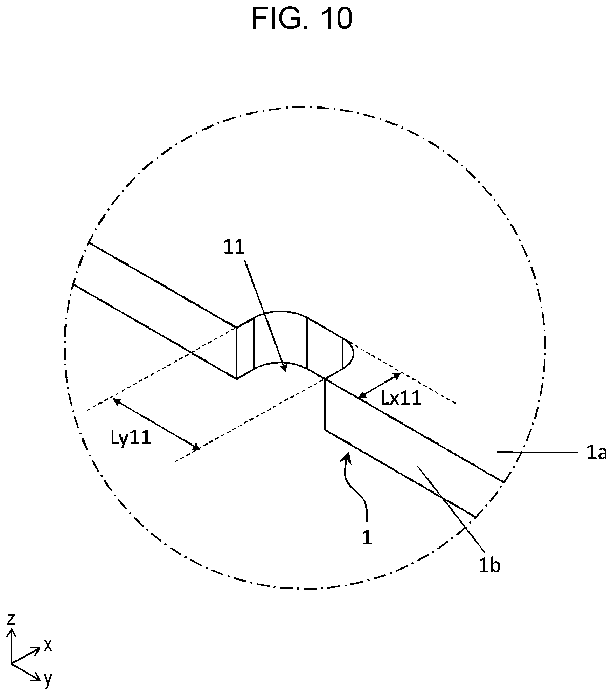

FIG. 10 illustrates the basal portion 1 according to variation 1. As illustrated in FIG. 10, the first opening 11 of the basal portion 1 is positioned to cross the first upper surface 1a, the first side surface 1b, and the first lower surface 1c. In other words, the first opening 11 penetrates the basal portion 1 from the first upper surface 1a to the first lower surface 1c and is positioned to cross the first side surface 1b.

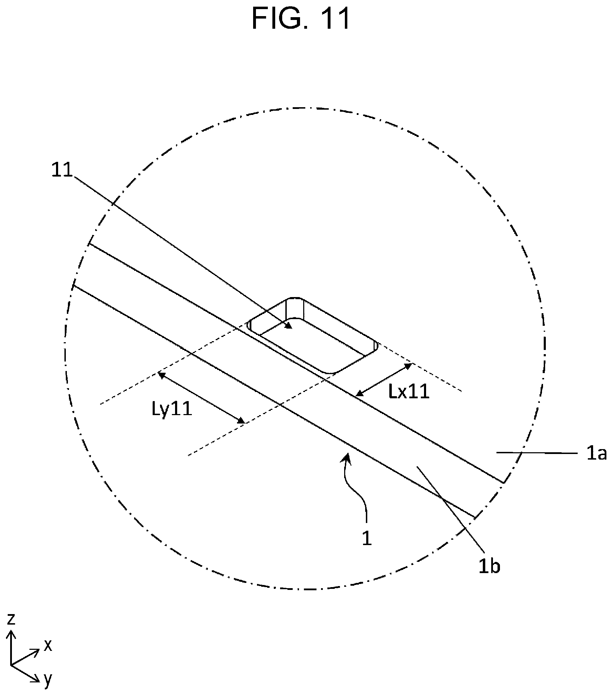

FIG. 11 illustrates the basal portion 1 according to variation 2. As illustrated in FIG. 11, the first opening 11 of the basal portion 1 is not necessarily positioned to cross the first side surface 1b. That is, the first opening 11 may be positioned to be spaced apart from the first side surface 1b. In this case, the first opening 11 may penetrate from the first upper surface 1a to the first lower surface 1c.

As illustrated in FIGs. 4 and 6, the second side surface 2b is flush with the first side surface 1b in a planar view in an embodiment. However, the second side surface 2b may alternatively be positioned apart from the first side surface 1b.

When the first signal conductor S1 is positioned in contact with the second side surface 2b in an embodiment as illustrated in FIG. 6, the first opening 11 is positioned to cross the first side surface 1b and can thus reduce the basal portion 1 positioned to be overlapped with the first signal conductor S1. This is further efficiently less likely to decrease the impedance at the first signal conductor S1.

When the first connector 31 to be described later is connected to the first signal conductor S1 as illustrated in FIG. 4, the impedance value can decrease around the second side surface 2b. The first opening 11 is positioned to cross the first side surface 1b so as to be less likely to decrease the impedance value at the first signal conductor S1 around the second side surface 2b.

As illustrated in FIG. 6, the first opening 11 has a maximum size Ly11 in the second direction (y direction) along the first side surface 1b, and the maximum size Ly11 may be equal to or more than the maximum size Ls1a in the second direction of the first joint S1P. That is, the first joint S1P may be positioned in the first opening 11 in the y direction in a planar view. This is less likely to decrease the impedance value when the first signal conductor S1 includes the first joint S1P for stable connection of the first connector 31 to be described later.

As illustrated in FIGs. 5 and 6, the dielectric substrate 2 may further include a first recess 21. The first recess 21 is positioned to cross the second upper surface 2a and the second side surface 2b in this case. The first recess 21 is positioned to be overlapped with the first opening 11 in a planar view. The first recess 21 may include a first inner wall surface 211. The first inner wall surface 211 is provided continuously to the second upper surface 2a and the second side surface 2b. The first signal conductor S1 (the first joint S1P) is positioned to extend so as to reach the first inner wall surface 211. In this case, the first recess 21 has a maximum size Ly21 in the y direction, which may be smaller than the maximum size Ls1a in the y direction of the first joint S1P in a planar view. The first signal conductor S1 is disposed in the y direction of the first recess 21 so as to be less likely to decrease the impedance value at the first signal conductor S1 as well as facilitate adjustment of the impedance value. The first signal conductor S1 positioned to extend so as to reach the first inner wall surface 211 can also be expressed as the first signal conductor S1 constituting a so-called castellation on the first inner wall surface 211. That is, the first signal conductor S1 is positioned also on the first inner wall surface 211. In an embodiment, the first recess 21 is positioned to cross the second upper surface 2a, the second side surface 2b, and the second lower surface 2c. In other words, the first recess 21 penetrates from the second upper surface 2a to the second lower surface 2c and is positioned in contact with the second side surface 2b in a planar view.

When the wiring board 101 further includes the first upper-surface ground conductor G21 and the second upper-surface ground conductor G22 described above as illustrated in FIGs. 3 to 6, the dielectric substrate 2 may include a third recess 23 and a fourth recess 24 positioned in the second upper surface 2a. The third recess 23 is positioned in contact with the second side surface 2b and the first upper-surface ground conductor G21. The fourth recess 24 is positioned in contact with the second side surface 2b and the second upper-surface ground conductor G22.

The third recess 23 may include a third inner wall surface 233 provided continuously to the second upper surface 2a and the second side surface 2b. In this case, the first upper-surface ground conductor G21 may be positioned to extend so as to reach the third inner wall surface 233.

The fourth recess 24 may include a fourth inner wall surface 244 provided continuously to the second upper surface 2a and the second side surface 2b. In this case, the second upper-surface ground conductor G22 may be positioned to extend so as to reach the fourth inner wall surface 244.

As illustrated in FIG. 5, in an embodiment, a maximum size Lz23 in the z direction of the third recess 23 and a maximum size Lz24 in the z direction of the fourth recess 24 may be equal to or different from a maximum size Lz21 in the z direction of the first recess 21. When the maximum size Lz23 in the z direction of the third recess 23 and the maximum size Lz24 in the z direction of the fourth recess 24 are equal to a size Lz2b in the z direction of the second side surface 2b of the dielectric substrate 2, the dielectric substrate 2 can achieve a better grounding state and the first signal conductor S1 can thus be improved in radio-frequency characteristics.

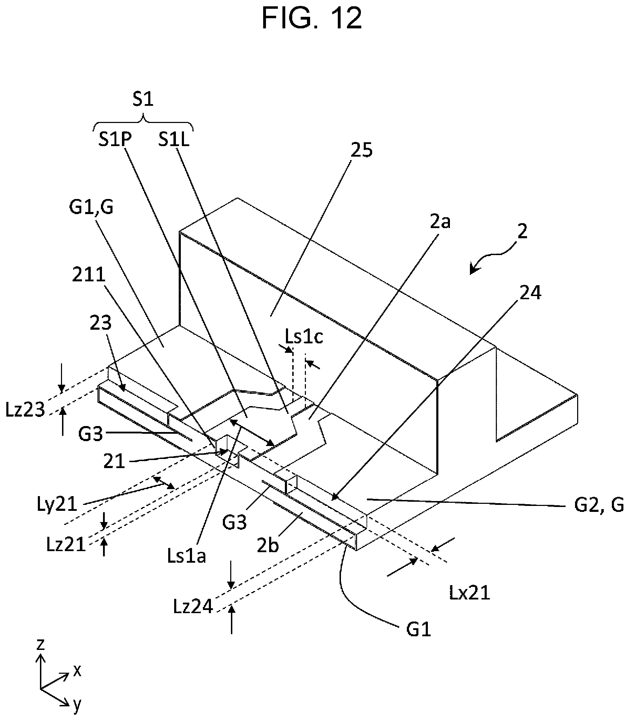

FIG. 12 illustrates a dielectric substrate 2 according to variation 1. In the dielectric substrate 2 according to variation 1, the first recess 21 is not positioned to penetrate to reach the second lower surface 2c as illustrated in FIG. 12. In other words, the first recess 21 is shaped to be cut off from the second upper surface 2a to the second side surface 2b.

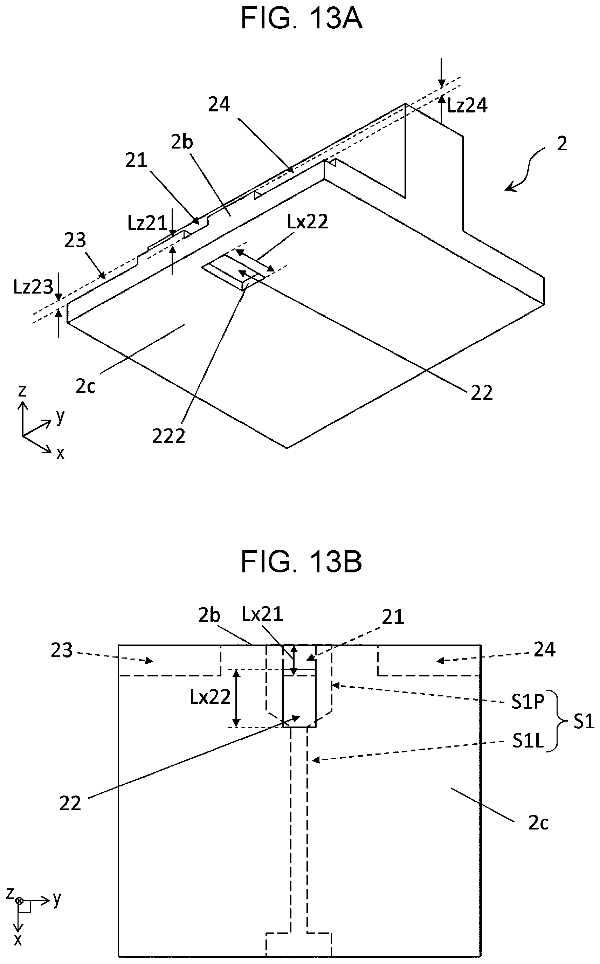

As illustrated in FIGs. 12, 13A, and 13B, a maximum distance Lx11 in the x direction from the first side surface 1b to an inner edge of the first opening 11 may be longer than a maximum size Lx21 in the x direction of the first recess 21 in a planar view. Such a configuration can secure a connection region between the first connector 31 to be described later and the first signal conductor S1 as well as is less likely to decrease the impedance value at the first signal conductor S1.

As illustrated in FIGs. 3 to 7, the wiring board 101 may further include the upper-surface ground conductor G2 and the internal-layer ground conductor G3. The upper-surface ground conductor G2 is positioned to be spaced apart from the first signal conductor S1 on the second upper surface 2a. The internal-layer ground conductor G3 is positioned in the dielectric substrate 2. The first joint S1P includes a first end portion S1e positioned adjacent to the second side surface 2b. The upper-surface ground conductor G2 includes a second end portion G21e (G22e) positioned adjacent to the second side surface 2b. The internal-layer ground conductor G3 includes a third end portion G3e positioned adjacent to the second side surface 2b. In an embodiment, the first joint S1P includes the protrusion S1a to be described later, and the protrusion S1a and the first end portion S1e are identical in this case. When the first joint S1P does not include the protrusion S1a, the first end portion S1e can also be called an outer edge portion of the first joint S1P proximate to the second side surface 2b. In an embodiment, the first recess 21 is interposed between first end portions S1e positioned symmetrically. Alternatively, the first end portion may be positioned only on one side of the first recess. The second end portion G21e (G22e) of the upper-surface ground conductor G2 can also be called the second end portion G21e of the first upper-surface ground conductor G21 and the second end portion G22e of the second upper-surface ground conductor G22. In an embodiment, the first end portion S1e, the second end portion G21e (G22e), and the third end portion G3e are exposed to the second side surface 2b, but are not necessarily exposed to the second side surface 2b.

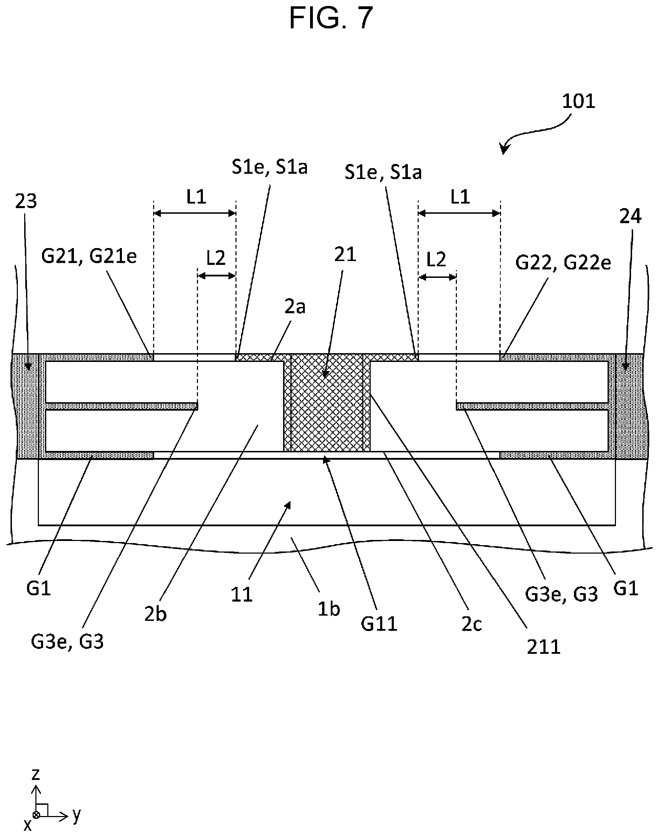

As illustrated in FIG. 7, in a side view or a planar view, a minimum distance L1 in the y direction between the first end portion S1e and the second end portion G21e (G22e) is larger than a minimum distance L2 in the y direction between the first end portion S1e and the third end portion G3e. Such a configuration is less likely to cause a short circuit due to contact between a dropping bonding material for connection of the first connector 31 to the first joint S1P and the upper-surface ground conductor G2 (the first upper-surface ground conductor G21 and the second upper-surface ground conductor G22). Furthermore, the first signal conductor S1 can be improved in radio-frequency characteristics when the internal-layer ground conductor G3 is disposed adjacent to the first signal conductor S1.

Each of the lower-surface ground conductor G1, the upper-surface ground conductor G2, and the internal-layer ground conductor G3 described above may be made of the material for the first signal conductor S1 or a different material. The lower-surface ground conductor G1, the upper-surface ground conductor G2, and the internal-layer ground conductor G3 can be formed in accordance with the same or a similar method to the method of forming the first signal conductor S1 or the like.

As illustrated in FIGs. 4 to 7, the first joint S1P may include the protrusion S1a. The protrusion S1a is provided on the second upper surface 2a along the second side surface 2b and projects in the y direction. Such a configuration facilitates adjustment of the impedance value because the first signal conductor S1 can have an additional capacitance component even when an inductive component is increased at a joint between the first connector 31 and an external substrate. In an embodiment, the protrusion S1a is in contact with the second side surface 2b in a planar view. In an embodiment, the first recess 21 is interposed between protrusions S1a positioned symmetrically. Alternatively, the protrusion may be positioned only on one side of the first recess.

As illustrated in FIGs. 2 to 4, the wiring board 101 may further include the first connector 31 electrically connected to at least part of the first joint S1P. In this case, the first connector 31 may include a first tip portion 31e overlapped with the first signal conductor S1 in a planar view. The first tip portion 31e may be positioned in the first opening 11 in a planar view. The impedance value can be decreased at a portion where the first connector 31 and the first joint S1P are overlapped with each other in a planar view. However, such a configuration as described above is less likely to decrease the impedance value at the first joint S1P.

The first connector 31 is constituted by a lead terminal in an embodiment. However, the first connector 31 is not limited to this case, and examples thereof may include a conductive member such as a wire, and a flexible printed circuit (FPC). The first connector 31 includes a tip that may be connected to a flexible printed circuit, or a printed circuit board provided with an electronic circuit. A second connector 32 and a third connector 33 to be described later may be configured identically or similarly to the first connector 31.

As illustrated in FIG. 4, the first connector 31 has a maximum size Ly31 in the y direction, which may be smaller than the maximum size Ly11 in the y direction of the first opening 11. That is, a portion where the first connector 31 and the first signal conductor S1 are overlapped with each other and that can have a decrease in impedance value is positioned in the first opening 11 in the y direction in a planar view. Such a configuration can facilitate adjustment of the impedance value at the first signal conductor S1.

As illustrated in FIG. 4, the maximum distance Lx11 in the x direction from the first side surface 1b to the inner edge of the first opening 11 may be longer than a maximum size L31e in the x direction from the first side surface 1b to the first tip portion 31e. That is, the portion where the first connector 31 and the first joint S1P are overlapped with each other and that can have a decrease in impedance value is positioned in the first opening 11 in the x direction in a planar view. Such a configuration can facilitate adjustment of the impedance value at the first signal conductor S1.

As illustrated in FIG. 4, at least part of the first connector 31 may be positioned to be overlapped with the first recess 21 in a planar view. The impedance value can be decreased when the first signal conductor S1 is increased in area (provided with the first j oint S1P) in order to bond the first connector 31 to the first signal conductor S1. However, provision of the first recess 21 is less likely to cause such a decrease in impedance value.

As in variation 1 illustrated in FIGs. 12, 13A, and 13B, the dielectric substrate 2 may further include the second lower surface 2c opposite to the second upper surface 2a, and a second recess 22 opened in the second lower surface 2c. In this case, the second recess 22 may be positioned to be overlapped with at least part of the first signal conductor S1 in a planar view as illustrated in FIG. 13B. Such a configuration can reduce the volume of the dielectric substrate 2 positioned to be overlapped with the first signal conductor S1 in a planar view. The second recess 22 is filled with air or a dielectric material such as a resin material or a glass material so as to be lower in dielectric constant than the dielectric substrate 2. This is less likely to cause a decrease in the impedance value at the first signal conductor S1 due to the dielectric substrate 2.

In variation 1 illustrated in FIGs. 13A and 13B, the dielectric substrate 2 includes the first recess 21 and the second recess 22. However, the dielectric substrate does not necessarily include the first recess 21 and may alternatively include only the second recess 22.

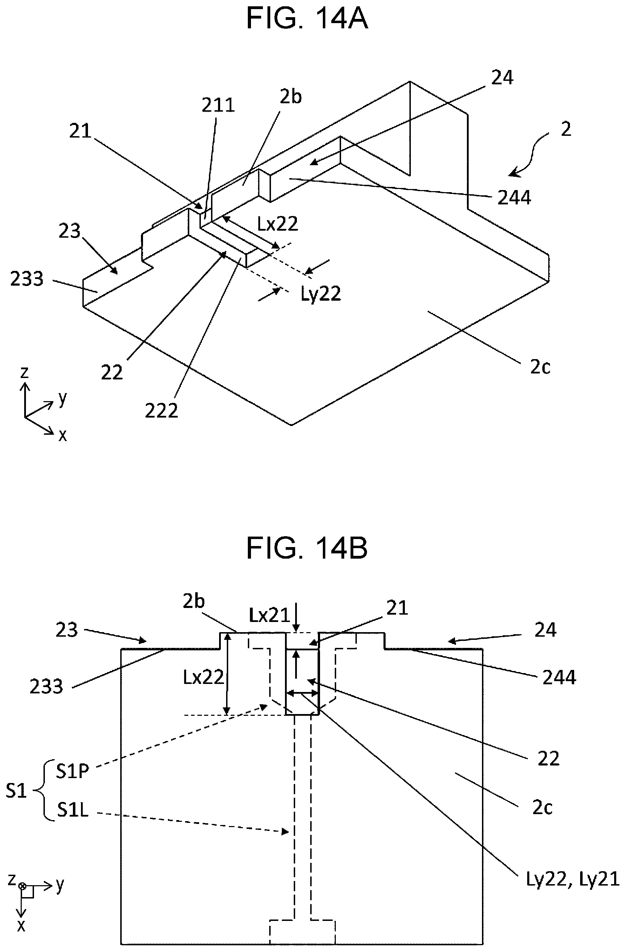

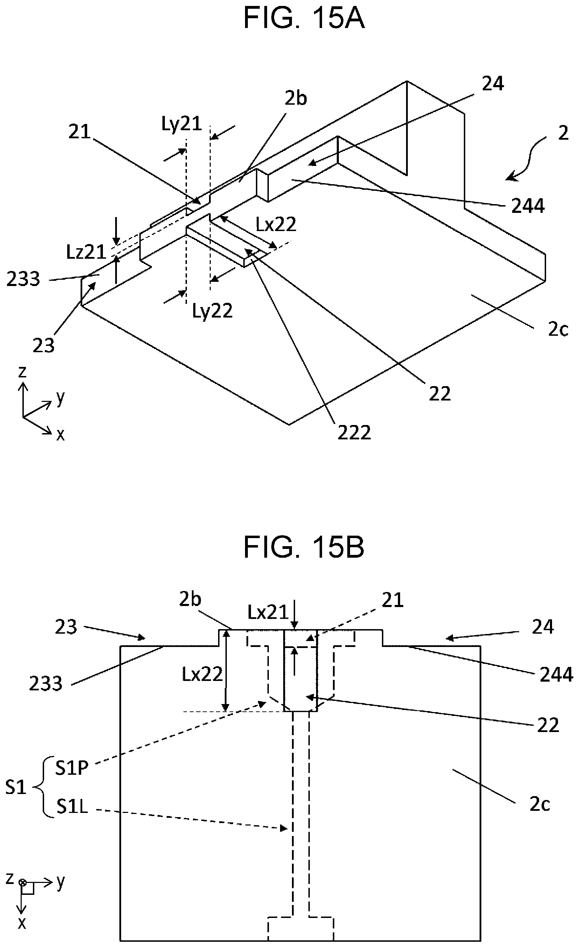

FIGs. 14A and 14B illustrate a dielectric substrate 2 according to variation 2, whereas FIGs. 15A and 15B illustrate a dielectric substrate 2 according to variation 3. As illustrated in FIGs. 14A, 14B, 15A, and 15B, the second recess 22 may be positioned to cross the second side surface 2b. In other words, the second recess 22 may be positioned to be cut off from the second lower surface 2c to the second side surface 2b.

When the dielectric substrate 2 includes the first recess 21 and the second recess 22, the first recess 21 and the second recess 22 may be positioned continuously as in the dielectric substrate 2 according to variation 2 illustrated in FIG. 14A. In the dielectric substrate 2 according to variation 2 illustrated in FIG. 14A, the first recess 21 and the second recess 22 are provided continuously in the second side surface 2b. In comparison to a case where the first recess 21 and the second recess 22 are positioned separately from each other, such a configuration can further decrease the dielectric substrate 2 overlapped with the first signal conductor S1 in a planar view and is thus less likely to decrease the impedance value. Such a configuration as described above does not need a dielectric layer provided between the first recess 21 and the second recess 22 and can thus reduce the height of the dielectric substrate 2 in comparison to the case where the first recess 21 and the second recess 22 are positioned separately from each other.

When the dielectric substrate 2 includes the first recess 21 and the second recess 22, the first recess 21 and the second recess 22 may be positioned separately from each other as in the dielectric substrate 2 according to variation 3 illustrated in FIG. 15A. Such a configuration can improve strength of the dielectric substrate 2 in comparison to the case where the first recess 21 and the second recess 22 are provided continuously.

As illustrated in FIGs. 13B, 14B, and 15B, the second recess 22 may be positioned to be overlapped with or may be positioned apart from the first recess 21 in a planar view. In comparison to the case where the second recess 22 is positioned apart from the first recess 21 in a planar view, when the second recess 22 is positioned to be overlapped with the first recess 21 in a planar view, the portion where the first signal conductor S1 and the first connector 31 are overlapped with each other can be covered continuously with the first recess 21 and the second recess 22 so as to be further less likely to decease the impedance value at the first signal conductor S1.

In a planar view, the second recess 22 may be positioned to be overlapped with at least part of the first opening 11. In this case, the second recess 22 has a maximum size Lx22 in the x direction, which may be equal to or less than the maximum distance Lx11 in the x direction of the first opening 11 in a planar view. Such a configuration is less likely to decrease the impedance value at the first signal conductor S1 as well as is less likely to deteriorate strength of the dielectric substrate 2.

The maximum size Lx22 in the x direction of the second recess 22 may match the maximum distance Lx11 in the x direction of the first opening 11. Such a configuration is further efficiently less likely to decrease the impedance value at the first signal conductor S1.

As illustrated in FIGs. 13B, 14B, and 15B, the maximum size Lx22 in the x direction of the second recess 22 may be larger than the maximum size Lx21 in the x direction of the first recess 21 in a planar view. Such a configuration can reduce the volume of the dielectric substrate 2 overlapped with the first connector 31 and can thus reduce the size of the wiring board 101.

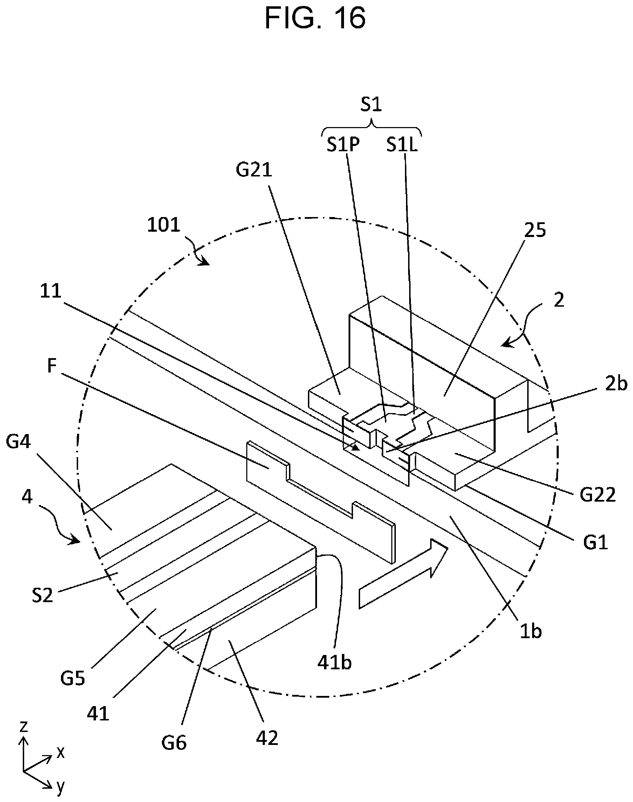

As illustrated in FIG. 16, The wiring board 101 may be electrically connected to an external substrate 4. The external substrate 4 includes a substrate 41, and a second signal conductor S2 positioned on an upper surface of the substrate 41. Though not illustrated, the first signal conductor S1 and the second signal conductor S2 are electrically connected to each other by the first connector 31 described above.

The external substrate 4 may include a first external upper-surface ground conductor G4 and a second external upper-surface ground conductor G5 positioned on the upper surface of the substrate 41. In this case, the second signal conductor S2 may be positioned between the first external upper-surface ground conductor G4 and the second external upper-surface ground conductor G5. The first external upper-surface ground conductor G4 and the first upper-surface ground conductor G21 may be electrically connected to each other by the second connector 32 described above. The second external upper-surface ground conductor G5 and the second upper-surface ground conductor G22 may be electrically connected to each other by the third connector 33 described above.

The external substrate 4 may include an external lower-surface ground conductor G6 positioned on a lower surface of the substrate 41. The external lower-surface ground conductor G6 may be electrically connected to at least one of the first external upper-surface ground conductor G4 and the second external upper-surface ground conductor G5 by a via or a castellation.

The external substrate 4 includes a substrate side surface 41b positioned to face the first side surface 1b of the basal portion 1. The substrate side surface 41B may be bonded to the first side surface 1b by a bonding material F having conductivity. In this case, the external lower-surface ground conductor G6 and the lower-surface ground conductor G1 may be electrically connected to each other by the bonding material F.

The bonding material F may be provided to reach part of the first upper surface 1a. Furthermore, the bonding material F does not need to reach the first opening 11 in order to be less likely to decrease the impedance value at the first signal conductor S1.

The bonding material F may be positioned to be spaced apart from the first signal conductor S1 and the second signal conductor S2 in a side view. Such a configuration is less likely to cause a short circuit due to contact between the bonding material F and the first signal conductor S1, the second signal conductor S2, or the first connector 31.

In an embodiment, the bonding material F may contain silver epoxy resin. Such silver epoxy resin contained in the bonding material F has higher viscosity in comparison to solder and brazing filler metal and is thus less likely to flow downward. The bonding material F can therefore be easily placed at a desired position. Examples of the bonding material F may include solder and brazing filler metal.

The external lower-surface ground conductor G6 and the lower-surface ground conductor G1 are electrically connected to each other via the bonding material F as described above so as to reduce a deviation in the ground potential between the external substrate 4 and the wiring board 101 and strengthen the grounding state. Accordingly, the first signal conductor S1 and the second signal conductor S2 can be improved in radio-frequency characteristics such as crosstalk characteristics for signal transmission.

As illustrated in FIG. 16, the external substrate 4 may include a seat portion 42 positioned below the substrate 41. In this case, the substrate 41 may be bonded directly to the seat portion 42, or may be bonded to the seat portion 42 via the external lower-surface ground conductor G6 when the external substrate 4 includes the external lower-surface ground conductor G6. In a side view, the bonding material F may also be provided between the substrate 41 and the seat portion 42. That is, at least one of the substrate 41 and the external lower-surface ground conductor G6 may be bonded to the seat portion 42 by the bonding material F.

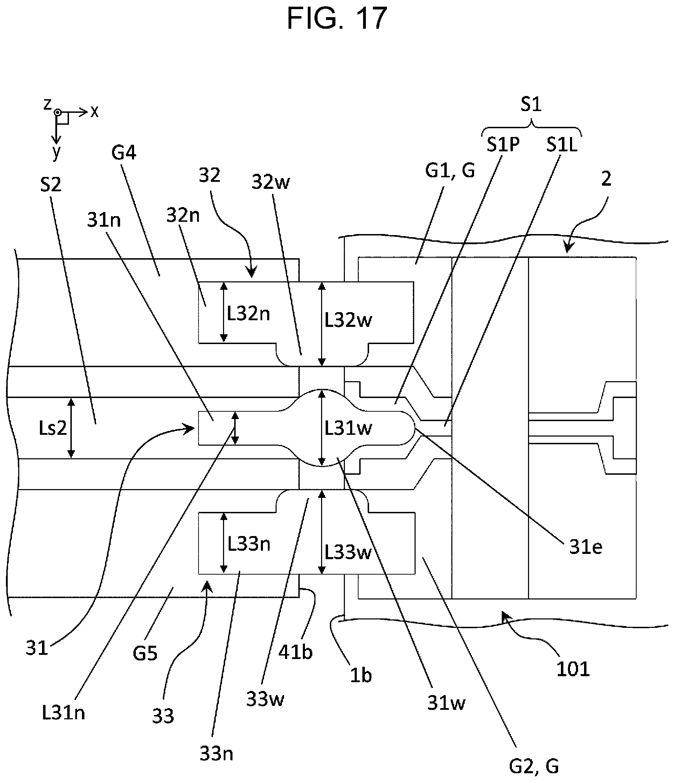

FIG. 17 is a plan view of a joint between the wiring board 101 and the external substrate 4, and a first connector 31 according to variation 1. The first connector 31 according to variation 1 includes a first narrow portion 31n and a first wide portion 31w. In a planar view, the first wide portion 31w has a size L31w in the y direction larger than a size L31n in the y direction of the first narrow portion 31n. The size L31w in the y direction of the first wide portion 31w may also be expressed as the maximum size in the y direction of the first connector 31. In the present variation, the first wide portion 31w has an arc shape and is provided continuously to the first narrow portion L31n in a planar view. In the present variation, the external connector 31 can also be expressed as being shaped to bulge at the first wide portion 31w in a planar view. The first wide portion 31w is shaped to be symmetric with respect to a longitudinal direction of the first connector 31. However, the first wide portion 31w is not necessarily shaped to be symmetric and may be positioned only on one side (e.g., the positive side in the y direction) of the first connector 31.

As illustrated in FIG. 17, the first wide portion 31w is positioned between the first side surface 1b and the substrate side surface 41b in a planar view. Such a configuration is less likely to cause a rapid impedance change upon signal transmission between the first signal conductor S1 and the second signal conductor S2, and is less likely to cause reflection of an unnecessary electrical signal on the first signal conductor S1 and the second signal conductor S2. The first side surface 1b is flush with the second side surface 2b in FIG. 17. Accordingly, the first wide portion 31n can also be expressed as being positioned between the second side surface 2b and the substrate side surface 41b in a planar view.

In FIG. 17, the size L31w in the y direction of the first wide portion 31w is larger than a size Ls2 in the y direction of the second signal conductor S2. The size L31w in the y direction of the first wide portion 31w may alternatively be smaller than or equal to the size Ls2 in the y direction of the second signal conductor S2. When the size L31w is larger than the size Ls2, the first connector 31 is less likely to cause a local impedance increase.

In FIG. 17, the size L31w in the y direction of the first wide portion 31w is smaller than the maximum size Ls1a in the y direction of the first joint S1P. The size L31w in the y direction of the first wide portion 31w may alternatively be larger than or equal to the maximum size Ls1a in the y direction of the first joint S1P.

FIG. 17 also illustrates a second connector 32 according to a variation and a third connector 33 according to a variation. In the present variation, the second connector 32 includes a second narrow portion 32n and a second wide portion 32w. The second narrow portion 32n and the second wide portion 32w can be defined identically or similarly to the first narrow portion 31n and the first wide portion 31w, respectively. The third connector 33 includes a third narrow portion 33n and a third wide portion 33w. The third narrow portion 33 and the third wide portion 33w can also be defined identically or similarly to the first narrow portion 31n and the first wide portion 31w, respectively.

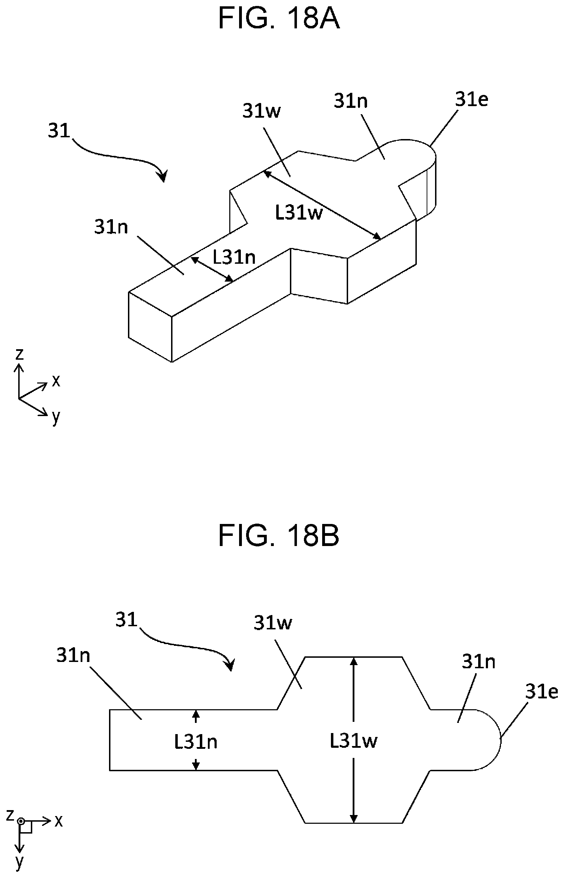

FIGs. 18A and 18B are views of a first connector 31 according to variation 2. Also in the present variation, the first connector 31 includes the first narrow portion 31n and the first wide portion 31w. The first connector 31 according to variation 2 is different from the first connector 31 according to variation 1 in that the first wide portion 31w has a linear shape in the y direction.

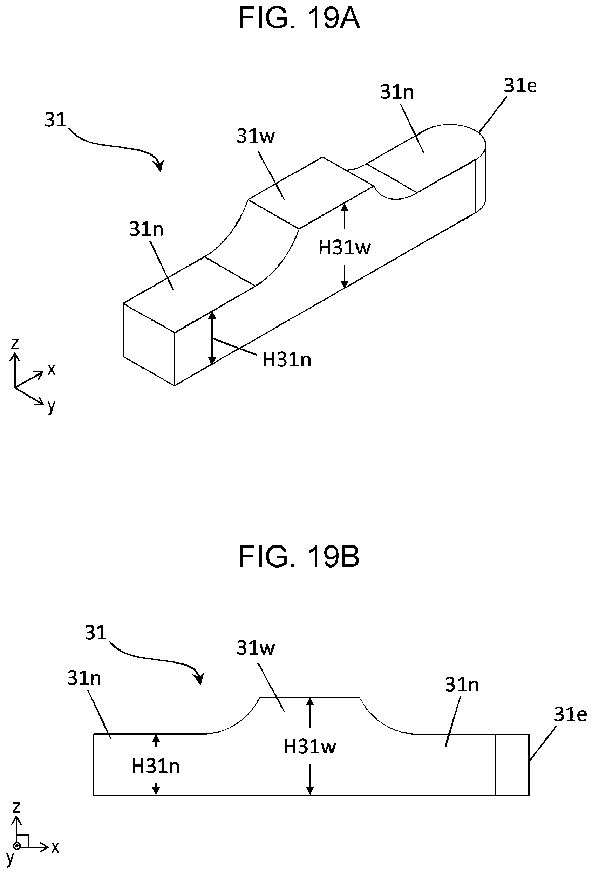

FIGs. 19A and 19B are views of a first connector 31 according to variation 3. Also in the present variation, the first signal conductor S1 includes the first narrow portion 31n and the first wide portion 31w. Accordingly, a size H31w in the z direction of the first wide portion 31w is larger than a size H31n in the z direction of the first narrow portion 31n in a planar view in the y direction.

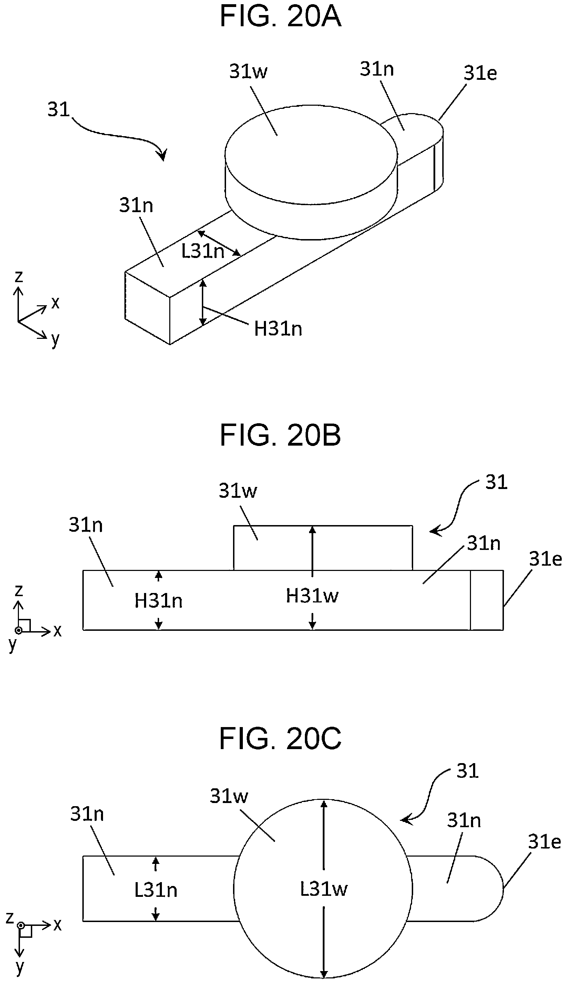

FIGs. 20A, 20B, and 20C are views of a first connector 31 according to variation 4. In the present variation, the size H31w in the z direction of the first wide portion 31w is larger than the size H31n in the z direction of the first narrow portion 31n in a planar view in the y direction (FIG. 20B), and the size L31w in the y direction of the first wide portion 31w is larger than the size L31n in the y direction of the first narrow portion 31n in a planar view (FIG. 20C).

FIGs. 17 to 20A, 20B, and 20C illustrate the first connectors 31 according to the variations. The second connector 32 and the third connector 33 may be shaped identically or similarly to the first connector 31 according to any of the variations.

### (Second Embodiment)

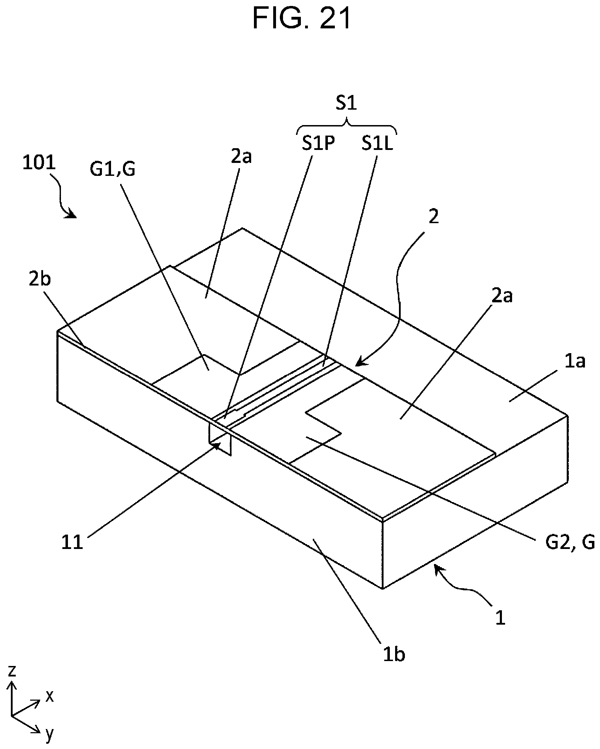

Description is made next to a wiring board 101 according to the second embodiment of the present disclosure with reference to FIGs. 21 to 23. Described hereinafter are only configurations according to the second embodiment different from the configurations according to the first embodiment. The remaining configurations will be denoted by reference signs identically or similarly to the first embodiment and will not be described repeatedly.

FIG. 21 illustrates the wiring board 101 according to the second embodiment including a printed circuit board as the dielectric substrate 2 differently from the first embodiment.

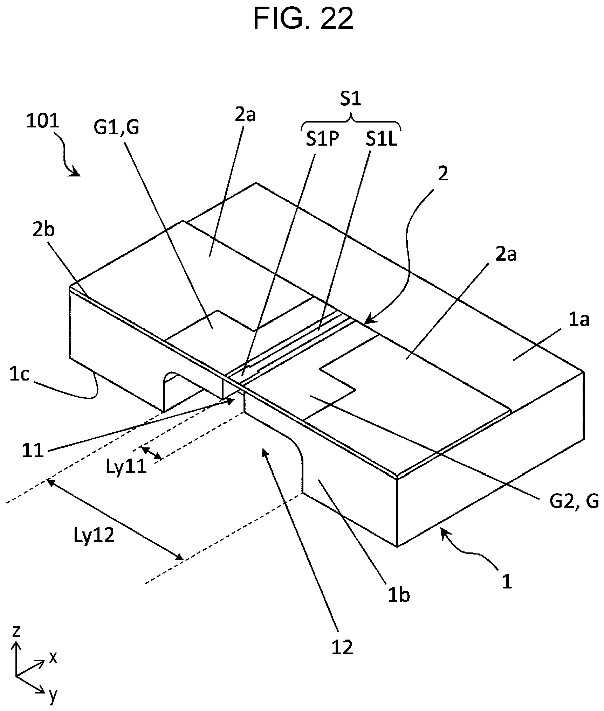

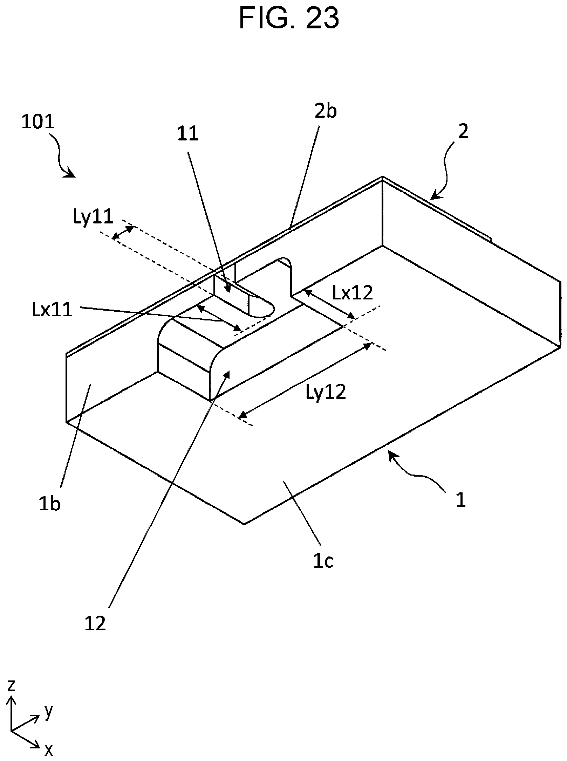

FIGs. 22 and 23 illustrate the wiring board 101 including a basal portion 1 according to variation 3. The basal portion 1 according to variation 3 is different from the basal portion 1 according to above embodiment in including a second opening 12. The second opening 12 is shaped to be cut off from the first lower surface 1c to the first side surface 1b. As illustrated in FIGs. 22 and 23, the second opening 12 has a maximum size Ly12 in the y direction, which may be larger than the maximum size Ly11 in the y direction of the first opening 11 in the present variation. A maximum distance Lx12 in the x direction from the first side surface 1b to an inner edge of the second opening 12 may be longer than the maximum distance Lx11 in the x direction from the first side surface 1b to the inner edge of the first opening 11. In other words, the first opening 11 may be positioned in the second opening 12 in a planar view.

### <Configuration of electronic component mounting package>

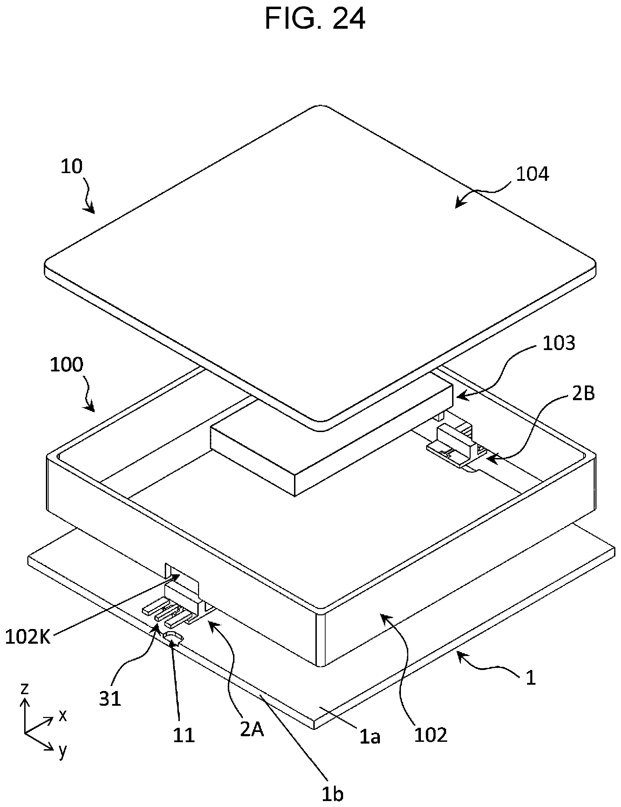

As illustrated in FIGs. 1 and 24, according to an embodiment of the present disclosure, an electronic component mounting package 100 includes a frame 102, and the wiring board 101 fixed to the frame 102. The frame 102 is bonded onto the basal portion 1 and the dielectric substrate 2. The frame 102 may alternatively be bonded onto only one of the basal portion 1 and the dielectric substrate 2.

The frame 102 is positioned on at least one of the basal portion 1 and the dielectric substrate 2, and protects the electronic component 103 positioned in the frame in a planar view. That is, the frame 102 is positioned to surround the electronic component 103 in a planar view. As illustrated in FIG. 1, the frame 102 and the dielectric substrate 2 surround the first upper surface 1a of basal portion 1 in an embodiment. In this manner, the frame 102 does not need to entirely surround the first upper surface 1a of the basal portion 1.

The frame 102 may have a rectangular shape in a planar view. In this case, the frame 102 and the basal portion 1 may interpose the dielectric substrate 2. As illustrated in FIG. 24, the frame 102 may include a cutout 102K provided to bond the dielectric substrate 2.

The frame 102 is made of a material, examples of which may include metallic materials such as copper, iron, tungsten, molybdenum, nickel, and cobalt, and an alloy containing any of these metallic materials. When the frame 102 is made of any one of the above metallic materials, the wiring board 101 can be fitted and bonded to the cutout 102K.

The frame 102 may alternatively be made of an insulating material, examples of which include a ceramic material such as an aluminum oxide sintered body, a mullite sintered body, a silicon carbide sintered body, an aluminum nitride sintered body, a silicon nitride sintered body, or a glass ceramic. The material for the frame 102 may be the same as the material for the dielectric substrate 2. In this case, the frame 102 and the dielectric substrate 2 can be formed integrally with each other.

The frame 102 can be bonded to the basal portion 1 via brazing filler metal or the like. The brazing filler metal is made of a material, examples of which include silver, copper, gold, aluminum, and magnesium, and the material may contain an additive such as nickel, cadmium, or phosphorus.

In an embodiment, the electronic component mounting package 100 is applicable to a package configured to be equipped with a semiconductor component for wireless communication or optical communication, or the like. In this case, the wiring board 101 can be exemplarily used in the electronic component mounting package 100 as an input-output terminal configured to electrically connect the electronic component 103 such as a semiconductor element and an external device as well as transmit, input, and output an electrical signal.

### <Configuration of electronic module>

As illustrated in FIG. 24, according to an embodiment of the present disclosure, an electronic module 10 includes the electronic component mounting package 100, the electronic component 103, and a lid 104. The electronic component 103 is positioned on the basal portion 1 or the dielectric substrate 2, and is electrically connected to the wiring board 101. The lid 104 is positioned on the frame 102 to cover an interior of the electronic component mounting package 100.

The electronic component 103 may be configured to process a signal, e.g., convert a wireless signal or an optical signal to an electrical signal or convert an electrical signal to an optical signal or a wireless signal. In an embodiment, the electronic component 103 is positioned on the basal portion 1, and is accommodated in the electronic component mounting package 100.

Examples of the electronic component 103 include an optical semiconductor element such as a semiconductor laser (LD) or a photodiode (PD), a semiconductor integrated circuit element, and a sensor element such as an optical sensor. The electronic component 103 can be made of a semiconductor material such as gallium arsenide or gallium nitride. When the electronic component 103 is an optical semiconductor element, the electronic module 10 can be utilized as an optical communication module.

The lid 104 is positioned on the frame 102 to cover the interior of the electronic component mounting package 100, such that the lid 104 and the frame 102 protect the electronic component 103. The lid 104 exemplarily has a quadrilateral shape in a planar view having 10 mm × 10 mm to 50 mm × 50 mm in size and 0.5 mm to 2 mm in thickness. The lid 104 is made of a material, examples of which include metallic materials such as iron, copper, nickel, chrome, cobalt, molybdenum, and tungsten, and an alloy obtained by combining any of these metallic materials. A metal member constituting the lid 104 can be manufactured by applying a metalworking method such as a metal rolling method or a punching method to an ingot made of such a metallic material.

The electronic module 10 may further include a seal ring positioned between the lid 104 and the frame 102. The seal ring has a function to bond the lid 104 and the frame 102. The seal ring is positioned on the frame 102 to surround the electronic component 103 in a planar view. The seal ring is made of a material, examples of which include metallic materials such as iron, copper, silver, nickel, chrome, cobalt, molybdenum, and tungsten, and an alloy obtained by combining any of these metallic materials. When the seal ring is not provided on the frame 102, the lid 104 may be bonded onto the frame 102 via an adhesive such as solder, brazing filler metal, glass, or a resin adhesive.

In an embodiment, characterized portions may be combined variously without being limited to exemplifications according to the above embodiments. Furthermore, combination is applicable among the variations.

According to an embodiment, the wiring board configured as described above achieves impedance adjustment at the first signal conductor when the wiring board is reduced in size.

This can improve signal transmission characteristics at the first signal conductor.

This accordingly achieves provision of the electronic component mounting package and the electronic module that can reduce losses in transmission of signals, particularly radio-frequency signals.

### INDUSTRIAL APPLICABILITY

The present disclosure is applicable to a wiring board, an electronic component mounting package including the wiring board, and an electronic module.

### REFERENCE SIGNS

1 basal portion
1a first upper surface
1b first side surface
1c first lower surface
11 first opening
12 second opening
2 dielectric substrate
2a second upper surface
2b second side surface
2c second lower surface
21 first recess
211 first inner wall surface
22 second recess
222 second inner wall surface
23 third recess
233 third inner wall surface
24 fourth recess
244 fourth inner wall surface
25 wall portion
31 first connector
31e first tip portion
31w first wide portion
31n first narrow portion
32 second connector
32w second wide portion
32n second narrow portion
33 third connector
33w third wide portion
33n third narrow portion
4 external substrate
41 substrate
41b substrate side surface
42 seat portion
S1 first signal conductor
S1P first joint
S1e first end portion
S1a protrusion
S1b second joint
S1L first line portion
S2 second signal conductor
G1 lower-surface ground conductor
G11 first opening region
G2 upper-surface ground conductor
G21 first upper-surface ground conductor
G21e second end portion
G22 second upper-surface ground conductor
G22e second end portion
G3 internal-layer ground conductor
G3e third end portion
G4 first external upper-surface ground conductor
G5 second external upper-surface ground conductor
G6 external lower-surface ground conductor
Lx11 maximum distance in x direction from first side surface to inner edge of first opening
Ly11 maximum size in y direction of first opening
Lx12 maximum distance in x direction from first side surface to inner edge of second opening
Ly12 maximum size in y direction of second opening
Lx21 maximum size in x direction of first recess
Ly21 maximum size in y direction of first recess
Lz21 maximum size in z direction of first recess
Lx22 maximum size in x direction of second recess
Ly22 maximum size in y direction of second recess
Lz22 maximum size in z direction of second recess
Lz23 maximum size in z direction of third recess
Lz24 maximum size in z direction of fourth recess
Ls1a maximum size in y direction of first joint
Ls1p maximum size in y direction of first joint except protrusion
Ls1c maximum size in y direction of first line portion
Ls1b size in y direction of second joint
Ls2 size in y direction of second signal conductor
L1 minimum distance between first joint and upper-surface ground conductor
L2 minimum distance between first joint and internal-layer ground conductor
L31w size in y direction of first wide portion
H31w size in z direction of first wide portion
L31n size in y direction of first narrow portion
H31n size in z direction of first narrow portion
F bonding material
10 electronic module
100 electronic component mounting package
101 wiring board
102 frame
102K cutout
103 electronic component
104 lid

## Claims

1. A wiring board comprising:
a basal portion including a first upper surface, a first lower surface opposite to the first upper surface, a first side surface connected to the first upper surface and the first lower surface, and a first opening opened in the first upper surface, and made of a metallic material;
a dielectric substrate including a second upper surface, a second lower surface opposite to the second upper surface, and a second side surface connected to the second upper surface and the second lower surface and positioned along the first side surface, and positioned on the first upper surface; and
a first signal conductor including a first line portion extending in a first direction to be away from the second side surface, and a first joint positioned between the first line portion and the second side surface, and positioned on the second upper surface; wherein
the first joint is larger in maximum size in a second direction along the first side surface than the first line portion, and
the first opening is positioned to be overlapped with at least part of the first joint in a planar view.

2. The wiring board according to claim 1,
the wiring board further comprising a lower-surface ground conductor positioned on the second lower surface and including a first opening region, wherein
in a planar view, the first opening region is positioned in the first opening and is positioned to be overlapped with the first joint.

3. The wiring board according to claim 1 or 2, wherein
the first opening is positioned to cross the first side surface.

4. The wiring board according to any one of claims 1 to 3, wherein the first opening is equal in maximum size to or more than the first joint in the second direction along the first side surface.

5. The wiring board according to any one of claims 1 to 4, wherein
the dielectric substrate further includes a first recess including a first inner wall surface,
the first recess crosses the second upper surface and the second side surface and is positioned to be overlapped with the first opening in a planar view,
the first inner wall surface is provided continuously to the second upper surface and the second side surface,
the first signal conductor is positioned to extend to reach the first inner wall surface, and
in a planar view, the first recess is smaller in maximum size than the first joint in the second direction along the second side surface.

6. The wiring board according to claim 5, wherein a maximum distance in the first direction from the first side surface to an inner edge of the first opening is longer than a maximum size in the first direction of the first recess in a planar view.

7. The wiring board according to any one of claims 1 to 6, the wiring board further comprising:
an upper-surface ground conductor positioned on the second upper surface to be spaced apart from the first signal conductor; and
an internal-layer ground conductor positioned in the dielectric substrate;
wherein
the first joint includes a first end portion positioned adjacent to the second side surface,
the upper-surface ground conductor includes a second end portion positioned adjacent to the second side surface,
the internal-layer ground conductor includes a third end portion positioned adjacent to the second side surface, and
in a side view, a minimum distance in the second direction between the first end portion and the second end portion is longer than a minimum distance in the second direction between the first end portion and the third end portion.

8. The wiring board according to any one of claims 1 to 7, wherein the first joint includes a protrusion provided on the second upper surface along the second side surface and projecting in the second direction.

9. The wiring board according to any one of claims 1 to 8, the wiring board further comprising
a first connector including a first tip portion overlapped with the first signal conductor in a planar view and electrically connected to the first joint, wherein
the first tip portion is positioned in the first opening in a planar view.

10. The wiring board according to claim 9, wherein a maximum size Ly31 in the second direction of the first connector is smaller than a maximum size Ly11 in the second direction of the first opening.

11. The wiring board according to claim 9 or 10, wherein a maximum distance Lx11 in the first direction from the first side surface to an inner edge of the first opening is larger than a maximum size L31e in the first direction from the first side surface to the first tip portion.

12. The wiring board according to claim 5 or 6, the wiring board further comprising
a first connector electrically connected to the first joint in a planar view, wherein
at least part of the first connector is positioned to be overlapped with the first recess in a planar view.

13. The wiring board according to any one of claims 1 to 12, wherein
the dielectric substrate further includes a second recess opened in the second lower surface, and
the second recess is positioned to be overlapped with at least part of the first signal conductor in a planar view.

14. The wiring board according to claim 13, wherein
the second recess is positioned to be overlapped with at least part of the first opening in a planar view, and
a maximum size Lx22 in the first direction of the second recess is equal to or less than a maximum distance Lx11 in the first direction of the first opening in a planar view.

15. The wiring board according to any one of claims 5, 6, or 12, wherein
the dielectric substrate further includes a second recess opened in the second lower surface,
the second recess is positioned to be overlapped with at least part of the first signal conductor in a planar view, and
a maximum size Lx22 in the first direction of the second recess is larger than a maximum size Lx21 in the first direction of the first recess in a planar view.

16. An electronic component mounting package comprising:
a frame bonded onto at least one of the basal portion and the dielectric substrate; and
the wiring board according to any one of claims 1 to 15 fixed to the frame.

17. An electronic module comprising:
the electronic component mounting package according to claim 16;
an electronic component positioned on the basal portion or the dielectric substrate and electrically connected to the wiring board; and
a lid positioned on the frame to cover an interior of the electronic component mounting package.
